# EUROPEAN PATENT APPLICATION

(11) **EP 2 302 112 A1**
(43) Date of publication of application: **30.03.2011**
(21) Application number: 09797961.1
(22) Date of filing: 16.07.2009
(51) Int. Cl.: C30B 29/38, H01L 21/205

(54) **ALGAN BULK CRYSTAL MANUFACTURING METHOD AND ALGAN SUBSTRATE MANUFACTURING METHOD**

(30) Priority: 17.07.2008 JP 2008186209
(71) Applicant: Sumitomo Electric Industries, Ltd., Chuo-ku Osaka-shi Osaka 540-0041 (JP)
(72) Inventor: MIYANAGA, Michimasa, Itami-shi Hyogo 664-0016 (JP); MIZUHARA, Naho, Itami-shi Hyogo 664-0016 (JP); TANIZAKI, Keisuke, Itami-shi Hyogo 664-0016 (JP); SATOH, Issei, Itami-shi Hyogo 664-0016 (JP); NAKAHATA, Hideaki, Itami-shi Hyogo 664-0016 (JP)
(74) Representative: Grünecker, Kinkeldey, Stockmair & Schwanhäusser Anwaltssozietät
(86) International application number: PCT/JP2009/062856
(87) International publication number: WO 2010/008037

(57) **Abstract**

There is provided an AlGaN bulk crystal manufacturing method for manufacturing a high-quality AlGaN bulk crystal having a large thickness. Also, there is provided an AlGaN substrate manufacturing method for manufacturing a high-quality AlGaN substrate. The AlGaN bulk crystal manufacturing method includes the following steps: First, a support substrate composed of AlₐGa₍₁₋ₐ₎N (0 < a ≤ 1) is prepared. Then, a bulk crystal composed of Al_{b}Ga_{(1-b)}N (0 < b< 1) with a primary surface is grown on the support substrate. The composition ratio a of Al in the support substrate is larger than the composition ratio b of Al in the bulk crystal. The AlGaN substrate manufacturing method includes a step of cutting out at least one Al_{b}Ga_{(1-b})N substrate from the bulk crystal.

## Description

### Technical Field

The present invention relates to an AlGaN bulk crystal manufacturing method and an AlGaN substrate manufacturing method.

### Background Art

AlₓGa₍₁₋ₓ₎N (0 < x < 1) (also referred to as "AlGaN") crystals are very useful as materials for forming light-emitting elements, electronic elements, and semiconductor devices such as semiconductor sensors.

Examples of methods for growing such AlGaN crystals include a method for growing by spontaneous nucleation without using a support substrate and a method for growing using a support substrate. It is difficult to stably grow large AlGaN crystals by the method for growing by spontaneous nucleation.

The method for growing an AlGaN crystal using a support substrate is disclosed in, for example, Japanese Unexamined Patent Application Publication No. 2004-331453 (Patent Literature 1) etc. Patent Literature 1 discloses that silicon (Si), sapphire (Al₂O₃), SiC (silicon carbide), ZrB₂ (zirconium boride), or a group III-V compound is used for the support substrate.

### Citation List

### Patent Literature

PTL 1: Japanese Unexamined Patent Application Publication No. 2004-331453

### Summary of Invention

### Technical Problem

However, the inventors have found that growth of an AlGaN crystal using a support substrate as in Patent Literature 1 has the problems below.

That is, the inventors have found that growth of an AlGaN crystal at a low temperature has the problem of deteriorating the quality of the AlGaN crystal. Specific forms of the deterioration include the presence of crystal defects such as dislocation or the like at a high density in the AlGaN crystal, the nonuniform AlGaN crystal due to the formation of large irregularity on a growth surface, and the like.

The inventors have found that when an AlGaN crystal is grown at a high temperature (e.g., 1200°C or more) in order to improve the quality of the AlGaN crystal, an AlGaN crystal having a large thickness cannot be grown due to vaporization and decomposition of the AlGaN crystal from the back side of the support substrate. When the AlGaN crystal has a small thickness, an AlGaN substrate cannot be cut out from the AlGaN crystal. Only a small number of AlGaN substrates can be cut out.

The present invention has been achieved in consideration of the above problems, and an object of the invention is to provide an AlGaN bulk crystal manufacturing method for manufacturing an AlGaN bulk crystal of high quality.

Another object of the invention is to provide an AlGaN substrate manufacturing method for manufacturing an AlGaN substrate of high quality.

### Solution to Problem

An AlGaN bulk crystal manufacturing method of the present invention includes the following steps: First, a support substrate composed of AlₐGa₍₁₋ₐ₎N (0 < a ≤ 1) is prepared. Then, a bulk crystal composed of Al_{b}Ga_{(1-b)}N (0 < b< 1) with a primary surface is grown on the support substrate. The composition ratio a of Al in the support substrate is larger than the composition ratio b of Al in the bulk crystal.

As a result of intensive research, the inventors have found that the decomposition temperature of a crystal increases as the Al composition ratio of a crystal increases. In the present invention, therefore, the composition ratio a of Al in AlₐGa₍₁₋ₐ₎N (0 < a ≤ 1) of the support substrate is larger than the composition ratio b of Al in Al_{b}Ga_{(1-b)}N (0 < b< 1) of the bulk crystal. Therefore, even when a bulk crystal is grown at a temperature required for growing a bulk crystal in which formation of irregularity is suppressed, vaporization and decomposition of the support substrate can be suppressed. Thus, a bulk crystal can be grown at a high temperature for a long time. Therefore, it is possible to grow a bulk crystal having a large thickness while suppressing formation of irregularity in a growth surface.

In addition, the composition ratio b of Al in the bulk crystal is smaller than the composition ratio a of Al in the support substrate. As the Al composition ratio decreases, a lattice constant increases. In a laminate of the support substrate and the bulk crystal, tensile stress is applied to the support substrate having a relatively small lattice constant so as to match with the bulk crystal having a relatively large lattice constant. Therefore, it is possible to suppress tensile stress from being applied to the bulk crystal, thereby suppressing the occurrence of cracks, defects, dislocation, and the like. Consequently, the crystallinity of the bulk crystal can be improved.

As described above, when the composition ratio a of Al in the support substrate is larger than the composition ratio b of Al in the bulk crystal, an AlGaN bulk crystal of high quality having a large thickness can be manufactured.

In the above-described AlGaN bulk crystal manufacturing method, a bulk crystal having a thickness of 1 mm or more is preferably grown in the growth step.

According to the AlGaN bulk crystal manufacturing method of the present invention, decomposition of the support substrate can be suppressed, and thus an AlGaN bulk crystal having a thickness of as large as 1 mm or more can be manufactured.

In the above-described AlGaN bulk crystal manufacturing method, the growth step preferably includes a step of growing a first layer containing a group III element diffused therein on the support substrate, and a step of growing a second layer composed of Al_{b}Ga_{(1-b)}N on the first layer.

When a bulk crystal is grown at a high temperature, a group III element constituting a support substrate diffuses into the bulk crystal. Therefore, the first layer disposed on the support substrate side in the bulk crystal contains the group III element. That is, the formation of the first layer corresponds to the growth of the bulk crystal at a high temperature. The formation of the first layer can effectively suppress the occurrence of irregularity in the second layer growth surface. Therefore, the quality of the bulk crystal can be further improved.

In the above-described AlGaN bulk crystal manufacturing method, in the growth step, the bulk crystal is preferably grown so that the Al concentration decreases from the support substrate side to the primary surface.

Therefore, tensile stress applied to the growth surface can be further suppressed. As a result, the AlGaN crystal of higher quality can be manufactured on the growth surface.

In the above-described AlGaN bulk crystal manufacturing method, in the growth step, the bulk crystal is preferably grown at 1650°C or more.

In the present invention, decomposition of the support substrate can be suppressed even in growth at a high temperature of 1650°C or more. Therefore, the formation of irregularity in the growth surface can be further suppressed.

In the above-described AlGaN bulk crystal manufacturing method, in the growth step, the bulk crystal is preferably grown so that the primary surface is any one of a c-plane, an a-plane, and an m-plane. In this case, a high-performance semiconductor element can be manufactured using the bulk crystal.

The above-described AlGaN bulk crystal manufacturing method, after the growth step, preferably further includes a step of removing at least the support substrate. As a result, a bulk crystal from which the support substrate is removed can be manufactured.

An AlGaN substrate manufacturing method of the present invention includes a step of manufacturing an AlGaN bulk crystal by the above-described AlGaN bulk crystal manufacturing method, and a step of cutting out at least one Al_{b}Ga_{(1-b)}N substrate from the bulk crystal.

According to the AlGaN substrate manufacturing method of the present invention, an AlGaN crystal of high quality with a large thickness which is manufactured by the AlGaN bulk crystal manufacturing method of the present invention is used. Therefore, an AlGaN substrate of high quality can be manufactured.

### Advantageous Effects of Invention

According to an AlGaN bulk crystal manufacturing method of the present invention, a support substrate having an Al composition ratio a larger than an Al composition ratio b of a bulk crystal is used, and thus an AlGaN bulk crystal of high quality having a large thickness can be manufactured.

According to an AlGaN substrate manufacturing method of the present invention, an AlGaN substrate of high quality can be manufactured using the AlGaN bulk crystal. Brief Description of Drawings

[Fig. 1] Fig. 1 is a sectional view schematically showing an AlGaN bulk crystal in Embodiment 1 of the present invention.
[Fig. 2] Fig. 2 is a flow chart showing an AlGaN bulk crystal manufacturing method in Embodiment 1 of the present invention.
[Fig. 3] Fig. 3 is a sectional view schematically showing a support substrate in Embodiment 1 of the present invention.
[Fig. 4] Fig. 4 is a sectional view schematically showing a state in which an AlGaN bulk crystal is grown in Embodiment 1 of the present invention.
[Fig. 5] Fig. 5 is a sectional view schematically showing a state in which another AlGaN bulk crystal is grown in Embodiment 1 of the present invention.
[Fig. 6] Fig. 6 is a sectional view schematically showing a state in which a support substrate is removed in Embodiment 1 of the present invention.
[Fig. 7] Fig. 7 is a sectional view schematically showing an AlGaN substrate in Embodiment 2 of the present invention.
[Fig. 8] Fig. 8 is a flow chart showing an AlGaN substrate manufacturing method in Embodiment 2 of the present invention.
[Fig. 9] Fig. 9 is a sectional view schematically showing a state in which an AlGaN substrate is cut out from an AlGaN bulk crystal in Embodiment 2 of the present invention.
[Fig. 10] Fig. 10 is a sectional view illustrating a method for confirming the presence of a first layer in an example.

### Description of Embodiments

Embodiments of the present invention are described below based on the drawings. In the drawings, the same portion or corresponding portions are denoted by the same reference numeral, and a description thereof is not repeated.

### (Embodiment 1)

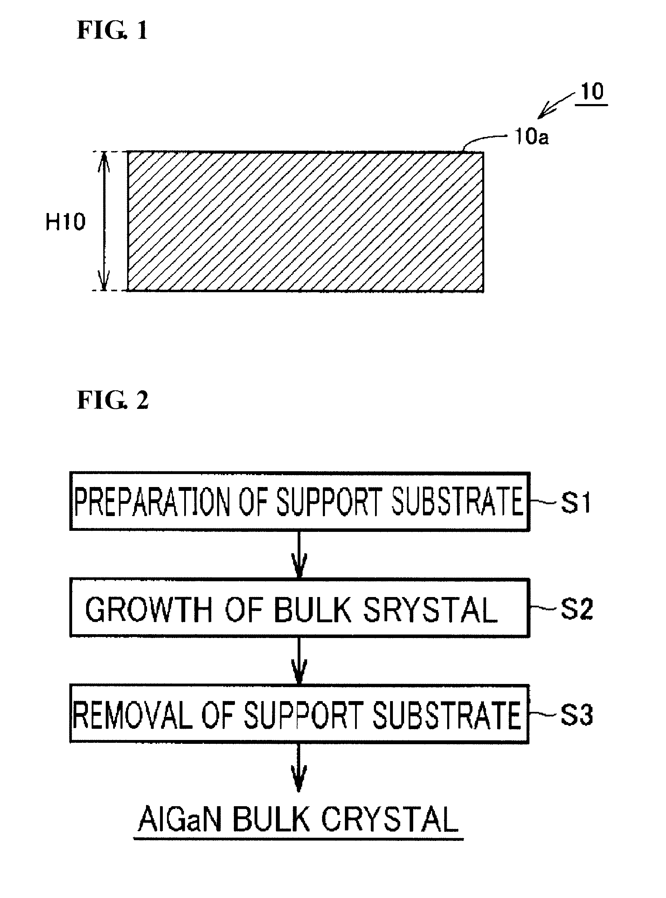

Figure 1 is a sectional view schematically showing an AlGaN bulk crystal according to an embodiment of the present invention. An AlGaN bulk crystal 10 according to this embodiment is described with reference to Fig. 1.

The AlGaN bulk crystal 10 according to the embodiment is Al_{b}Ga_{(1-b)}N (0 < b < 1). The AlGaN bulk crystal 10 has a primary surface 10a. The primary surface 10a is preferably, for example, any one of a {1000} plane (c-plane), a {11-20} plane (a-plane), and a {1-100} plane (m-plane). From a crystallographic viewpoint, brackets {} represent a family of planes, and a negative index is shown by placing "-" (bar) above a number, but in this specification, a negative index is shown by placing a minus sign before a number.

The AlGaN bulk crystal 10 preferably has a dislocation density of 1 × 10⁸ cm⁻² or less, more preferably 1 × 10⁷ cm⁻² or less, still more preferably 1 × 10⁶ cm⁻² or less, and most preferably 5 × 10⁵ cm⁻² or less. In this case, when a device is manufactured using an AlGaN substrate 20 formed from the AlGaN bulk crystal, characteristics of the device can be improved. A dislocation density can be measured by, for example, a method of counting a number of pits produced by etching in molten KOH (potassium hydroxide) and dividing the number by a unit area.

The AlGaN bulk crystal 10 preferably has a thickness H10 of 1 mm or more, more preferably 2 mm or more, and still more preferably 4 mm or more. With a thickness of 1 mm or more, a larger number of AlGaN substrates can be manufactured from the AlGaN bulk crystal 10, thereby decreasing the cost required for manufacturing an AlGaN substrate. In addition, defects such as dislocation can be decreased by thickening the AlGaN bulk crystal 10, and thus a high-quality AlGaN crystal 10 can be formed.

Figure 2 is a flow chart showing an AlGaN bulk crystal manufacturing method according to the embodiment of the present invention. The AlGaN bulk crystal manufacturing method according to the embodiment of the present invention is described with reference to Fig. 2.

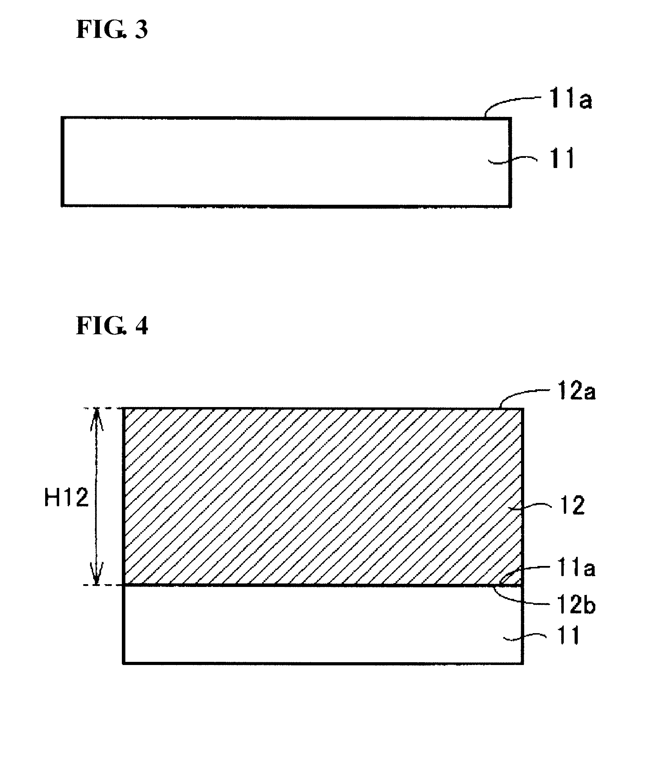

Figure 3 is a sectional view schematically showing a support substrate in the embodiment of the present invention. As shown in Figs. 2 and 3, first, a support substrate 11 composed of AlₐGa₍₁₋ₐ₎N (0 < a ≤ 1) is prepared (Step S1). The composition ratio a of Al in the support substrate 11 prepared in Step S1 is larger than the composition ratio b of Al in an AlGaN bulk crystal 12 to be grown in Step S2 described below. The composition ratios a and b of Al in the support substrate 11 and the AlGaN bulk crystal 12 are molar ratios of Al.

The decomposition temperature of a crystal constituting the support substrate 11 increases as the composition ratio a of Al in the support substrate 11 increases. Therefore, even when an AlGaN bulk crystal is grown at a high temperature in Step S2 described below, decomposition of the support substrate 11 can be suppressed, and thus an AlGaN bulk crystal having a large thickness can be grown. From the viewpoint of resistance to vaporization and decomposition, the composition ratio a of Al in the support substrate 11 is preferably as large as possible, and for example, the composition ratio a is preferably 0.8 or more and more preferably 1.

In Step S1, the support substrate 11 having a primary surface 11a with a size of, for example, 2 inches or more in diameter is preferably prepared. Consequently, an AlGaN bulk crystal with a large diameter can be grown.

Figure 4 is a sectional view schematically showing a state in which an AlGaN bulk crystal is grown according to the embodiment of the present invention. Next, as shown in Figs. 2 and 4, the AlGaN bulk crystal 12 having a primary surface 12a and composed of Al_{b}Ga_{(1-b)}N (0 < b < 1) is grown on the support substrate 11 (Step S2). The composition ratio b of Al in the AlGaN bulk crystal 12 grown in Step S2 is smaller than the composition ratio a of Al in the support substrate 11 prepared in Step S1. Namely, a relation of a > b is established between the composition ratio a of Al in the support substrate 11 and the composition ratio b of Al in the AlGaN bulk crystal 12. Preferably a relation of a > b > 0.5a, more preferably a relation of 0.7a ≥ b ≥ 0.125a, is established between the composition ratio a of Al in the support substrate 11 and the composition ratio b of Al in the AlGaN bulk crystal 12. In this case, decomposition of the support substrate 11 can be further suppressed, and the high-quality AlGaN bulk crystal 12 can be grown.

In Step S2, the AlGaN bulk crystal 12 is grown at a high temperature which can suppress the formation of irregularity in the growth surface (primary surface 12a). Even when the AlGaN bulk crystal 12 is grown at a high temperature, decomposition of the support substrate 11 can be suppressed because the support substrate 11 has a high composition ratio a of Al according to the embodiment. Therefore, the formation of irregularity in the growth surface can be suppressed, and the AlGaN bulk crystal 12 having a large thickness can be grown.

Specifically, the growth temperature of the AlGaN bulk crystal 12 is preferably 1650°C or more and more preferably 1650°C or more and 1800°C or less. When the temperature is 1650°C or more, the primary surface 12a of the AlGaN bulk crystal 12, which is the growth surface, can be made very flat. When the temperature is 1800°C or less, decomposition of the support substrate 11 can be effectively suppressed, thereby increasing the thickness H12. The growth temperature represents, for example, the temperature of the support substrate 11.

In addition, the AIGaN bulk crystal 12 having a large thickness H12 which is preferably 1 mm or more, more preferably 2 mm or more, and still more preferably 4 mm or more can be grown. Although there is no upper limit of the thickness H12, in the embodiment, the AlGaN bulk crystal 12 having a thickness H12 of, for example, 50 mm or less can be easily manufactured.

As the composition ratios a and b of Al decrease, a lattice constant increases. In Step S2, the composition ratio b of Al in the AlGaN bulk crystal 12 is smaller than the composition ratio a of Al in the support substrate 11. In a laminate of the support substrate 11 and the AlGaN bulk crystal 12, tensile stress is applied so that the support substrate 11 having a relatively small lattice constant is matched with the AlGaN bulk crystal 12 having a relatively large lattice constant. Therefore, it is possible to suppress tensile stress from being applied to the AlGaN bulk crystal 12, thereby suppressing the occurrence of cracks, defects, dislocation, and the like in the AlGaN bulk crystal 12. Therefore, crystallinity of the AlGaN bulk crystal 12 can be improved.

The dislocation density which is an index for crystallinity of the AlGaN bulk crystal 12 is preferably 1 × 10⁸ cm⁻² or less, more preferably 1 × 10⁷ cm⁻² or less, still more preferably 1 × 10⁶ cm⁻² or less, and most preferably 5 × 10⁵ cm⁻² or less. In the embodiment, the composition ratio b of Al in the AlGaN bulk crystal 12 is smaller than the composition ratio a of Al in the support substrate 11, and thus the AlGaN bulk crystal 12 having such a dislocation density can be grown.

When the AlGaN bulk crystal 12 is grown so that the Al concentration decreases from the support substrate 11 side (back side 12b) to the growth surface (primary surface 12a), tensile stress applied to the growth surface can be further suppressed, and consequently the dislocation density can be further decreased. That is, the composition ratio b of the AlGaN bulk crystal 12 is not limited to being constant, but the composition ratio b may monotonically decrease toward the growth surface. The expression "monotonically decrease" represents that the composition ratio b is always constant or decreases from the back side 12b on the support substrate 11 side to the primary surface 12a which is the growth surface (in the growth direction), and the composition ratio b of the primary surface 12a is lower than that of the back side 12b. Namely, the expression "monotonically decrease" does not include the case in which the composition b increases in the growth direction.

In Step S2, the AlGaN bulk crystal 12 is grown preferably at a growth rate of 30 µm/hr or more, more preferably 100 µm/hr or more and 180 µm/hr or less. Since the AlGaN bulk crystal 12 can be grown at a high temperature as described above, the growth rate can be increased to such a value. Therefore, the AlGaN bulk crystal 12 can be manufactured with a high manufacturing efficiency.

In Step S2, the AlGaN bulk crystal 12 is preferably grown so that the primary surface 12a is any one of the c-plane, the a-plane, and the m-plane, In this case, a high-performance semiconductor element can be manufactured using the AIGaN bulk crystal 12.

The method for growing the AlGaN bulk crystal 12 is not particularly limited, and a vapor phase growth method such as a sublimation growth method, a HVPE (Hydride Vapor Phase Epitaxy) method, a MBE (Molecular Beam Epitaxy) method, or a MOCVD (Metal Organic Chemical Vapor Deposition) method, a liquid phase method such as a flux growth method, a high-nitrogen pressure solution growth method, or the like can be used. In Step S2, the sublimation growth method is preferably used from the viewpoint that growth can be performed at a very high temperature.

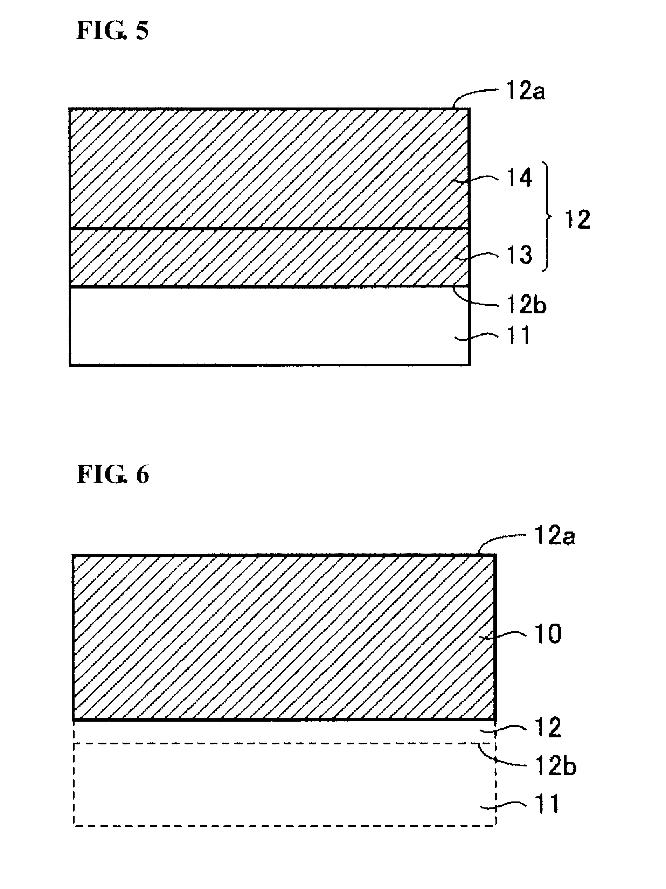

Figure 5 is a sectional view schematically showing a state in which another AlGaN bulk crystal is grown in the embodiment of the present invention. As shown in Fig. 5, growth Step S2 may include a step of growing a first layer 13 in which a group III element is diffused on the support substrate 11, and a step of growing a second layer 14 composed of Al_{b}Ga_{(1-b)}N on the first layer 13. In detail, in the AlGaN bulk crystal 12, the first layer 13 contains a large amount of Al, and the second layer 14 contains a large amount of Ga. In the first layer 13, the Al amount is relatively large on the support substrate side, and the Ga amount is relatively large on the interface side with the second layer 14. The interface between the first and second layers 13 and 14 can be measured by, for example, SIMS (Secondary Ion Mass Spectrometry).

When the AlGaN bulk crystal 12 is grown at a high temperature, a group III element (Al element or Al element and Ga element) constituting the support substrate 11 diffuses, and thus the first layer 13 disposed on the support substrate 11 side in the AlGaN bulk crystal 12 contains the group III element. Namely, when the AlGaN bulk crystal 12 is grown at a high temperature, the first layer 13 is formed. By forming the first layer 13, the occurrence of irregularity in the growth surface of the second layer 14 can be more effectively suppressed. The growth temperature is for example 1650°C or more. The growth at such a high temperature can further improve quality of the primary surface 12a side of the AlGaN bulk crystal 12.

Although the case in which the AlGaN bulk crystal 12 includes two layers is described by giving an example with reference to Fig. 5, the AlGaN bulk crystal 12 may include three or more layers.

Figure 6 is a sectional view schematically showing a state in which a support substrate is removed in this embodiment of the present invention. Next, as shown in Figs. 2 and 6, at least the support substrate 11 is removed (Step S3). Step S3 may not be performed.

The removal method is not particularly limited, but, for example, a method such as cutting, cleavage, or the like can be used. In the removal, the AlGaN bulk crystal 12 (in this embodiment, the AlGaN bulk crystal 10) is cut out from a laminate of the support substrate 11 and the AlGaN bulk crystal 12. In this case, only the support substrate 11 may be removed from the laminate of the support substrate 11 and the AlGaN bulk crystal 12 or a portion including the interface (back side 12b) between the AlGaN bulk crystal 12 and the support substrate 11 in the AlGaN bulk crystal 12 may be further removed. When a portion including the back side 12b is further removed, the AlGaN bulk crystal 12 can be easily separated because it is composed of a single crystal.

Cutting includes mechanically removing at least the support substrate 11 with a slicer having an outer cutting edge of an electroplated diamond wheel. Cleavage includes removing at least the support substrate 11 along a crystal lattice plane.

In Step S3 of removing the support substrate 11, the AlGaN bulk crystal 10 is preferably cut out so that the primary surface 10a is any one of the c-plane, the a-plane, and the m-plane. When the AlGaN bulk crystal 12 is grown so that the primary surface 10a is any one of the c-plane, the a-plane, and the m-plane, the AlGaN bulk crystal 10 having the primary surface 10a with the same plane orientation as the AlGaN bulk crystal 12 can be manufactured by cutting out the AlGaN bulk crystal 12 in parallel with the primary surface 12a of the crystal 12.

The AlGaN bulk crystal 10 shown in Fig. 1 can be manufactured by performing Steps S1 to S3.

As described above, in the method for manufacturing the AlGaN bulk crystal 10 or 12 according to the embodiment, the composition ratio a of Al in the support substrate 11 is larger than the composition ratio b of Al in the AlGaN bulk crystal 12.

As described above, when the AlGaN bulk crystal 12 is grown at a high temperature, the formation of irregularity in the growth surface (primary surface 12a) can be suppressed. In addition, the method for manufacturing the AlGaN bulk crystal 10 or 12 according to the embodiment is capable of suppressing decomposition of the support substrate 11 even when the AlGaN bulk crystal 12 is grown at a high temperature. Therefore, the manufacturing method of the present invention is capable of suppressing the formation of irregularity in the growth surface and manufacturing the AlGaN bulk crystal 10 or 12 having large thickness H10 or H12.

In addition, a lattice constant increases as the composition ratio of Al decreases. Therefore, in a laminate of the support substrate 11 and the AlGaN bulk crystal 12, tensile stress is suppressed from being applied to the AlGaN bulk crystal 12 having a relatively large lattice constant. As a result, introduction of cracks, defects, and the like in the AlGaN bulk crystal 12 can be suppressed, and thus the high-quality AlGaN bulk crystal 10 or 12 can be manufactured.

Further, when an AlGaN bulk crystal is grown at a low temperature as in a usual method, Al₂O₃, Ga₂O₃ (gallium oxide), and the like contained in raw materials or produced from the raw materials are incorporated into the AlGaN bulk crystal 12. In this case, a pit or the like is formed in the AlGaN bulk crystal 10 or 12, thereby often producing polycrystals. However, in this embodiment, even when the AlGaN bulk crystal 12 is grown at a high temperature, decomposition of the support substrate 11 can be suppressed. Therefore, in the method of the present invention, the crystal 12 is generally grown at a high temperature. The growth of the crystal 12 at a high temperature causes decomposition of Al₂O₃, Ga₂O₃, and the like, and thus Al₂O₃, Ga₂O₃, and the like can be suppressed from being directly incorporated into the AlGaN bulk crystal 12. As a result, the formation of polycrystals can be suppressed, and the high-quality AlGaN bulk crystal 10 or 12 can be manufactured.

Therefore, when the composition ratio a of Al in the support substrate 11 is larger than the composition ratio b of Al in the AlGaN bulk crystal 12, the high-quality AlGaN bulk crystal 10 or 12 having a large thickness H10 or H12 can be stably manufactured with high reproducibility.

### (Embodiment 2)

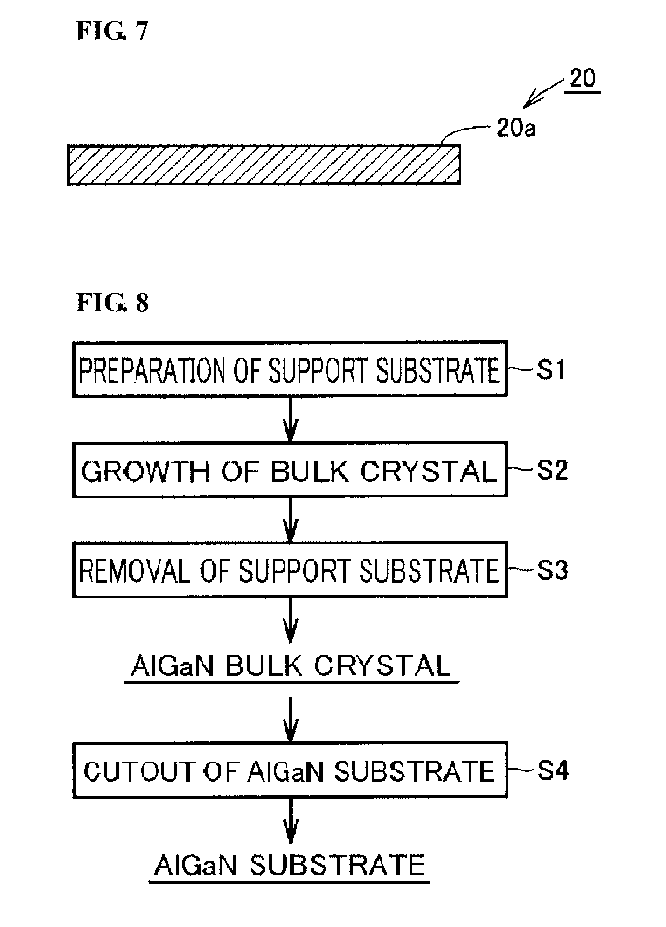

Figure 7 is a sectional view schematically showing an AlGaN substrate according to an embodiment of the present invention. An AlGaN substrate according to this embodiment is described with reference to Fig. 7.

As shown in Fig. 7, an AlGaN substrate 20 according to this embodiment is formed using the AlGaN bulk crystal 10 or 12 according to Embodiment 1. Namely, the AlGaN substrate 20 is composed of Al_{b}Ga_{(1-b)}N (0 < b < 1).

The AlGaN substrate 20 has a primary surface 20a, and the primary surface 20a is preferably any one of the c-plane, the a-plane, and the m-plane.

Figure 8 is a flow chart showing an AlGaN substrate manufacturing method according to the embodiment. Next, the AlGaN substrate manufacturing method according to the embodiment is described with reference to Fig. 8.

As shown in Fig. 8, first, the AlGaN bulk crystal 10 or 12 is manufactured by the AlGaN bulk crystal manufacturing method according to Embodiment 1 (Steps S1 to S3). Steps S1 to S3 are substantially the same as in Embodiment 1, and thus a description thereof is not repeated.

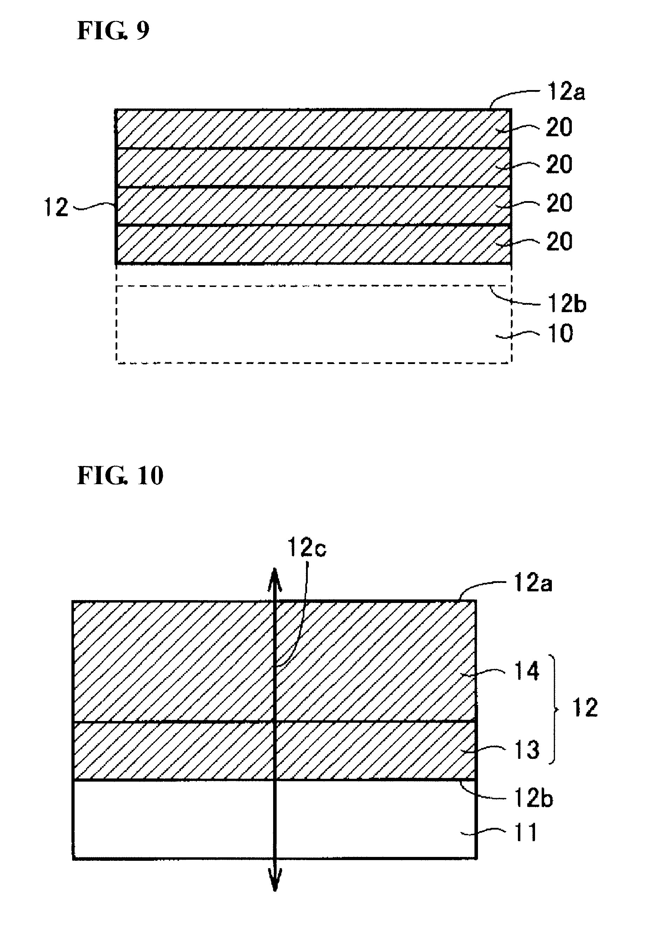

Figure 9 is a sectional view schematically showing a state in which an AlGaN substrate is cut out from an AlGaN bulk crystal according to this embodiment. As shown in Figs. 8 and 9, next, an AlGaN substrate 20 is cut out from the AlGaN bulk crystal 10 or 12 (Step S4). The AlGaN substrate 20 cut out in Step S4 is composed of Al_{b}Ga_{(1-b)}N (0 < b < 1).

In Step S4, one AlGaN substrate 20 may be cut out, but a plurality of AlGaN substrates 20 are preferably cut out. Since the AlGaN bulk crystal 10 or 12 having a large thickness H10 or H12 is manufactured in Embodiment 1, a plurality of AlGaN substrates 20 can be easily cut out.

A cutout method is not particularly limited, but the AlGaN substrate 20 can be separated from the AlGaN bulk crystal 10 or 12 by cutting or cleavage.

The AlGaN substrate 20 shown in Fig. 7 can be manufactured by performing Steps S1 to S4.

As described above, according to the method for manufacturing the AlGaN substrate 20 of this embodiment, at least one AlGaN substrate 20 can be cut out from the bulk crystal 10 or 12 of Embodiment 1 (Step S4).

According to the method for manufacturing the AlGaN substrate 20 of this embodiment, the high-quality AlGaN substrate 20 can be manufactured because the AlGaN bulk crystal 10 or 20 has high quality.

In addition, since the AlGaN bulk crystal 10 or 20 has a large thickness H10 or H12, a plurality of AlGaN substrates 20 can be cut out from the AlGaN bulk crystal 10 or 20 of Embodiment 1. In this case, the manufacturing cost per AlGaN substrate 20 can be decreased.

The AlGaN substrate 20 manufactured according to this embodiment can be preferably used as substrates for light-emitting elements such as a light-emitting diode, a laser diode, and the like; electronic elements such as a rectifier, a bipolar transistor, a field-effect transistor, HEMT (High Electron Mobility Transistor), and the like; semiconductor sensors such as a temperature sensor, a pressure sensor, a radiation sensor, a visible-ultraviolet sensor, and the like; and devices such as a SAW device (Surface Acoustic Wave Device), a vibrator, a resonator, an oscillator, a MEMS (Micro Electro Mechanical System) part, a piezoelectric actuator, and the like.

### EXAMPLES

In examples, the effect of a condition in which a composition ratio a of Al in a support substrate is larger than a composition ratio b of Al in a bulk crystal was examined. EXAMPLES 1 to 4

AlGaN bulk crystals of Examples 1 to 4 were manufactured according to the above-described AlGaN bulk crystal manufacturing method of Embodiment 1.

Specifically, first a support substrate composed of AlₐGa₍₁₋ₐ₎N (0 < a ≤ 1) was prepared (Step S1). The composition ratio a of Al was as shown in Table I below. A primary surface of the support substrate was the c-plane.

Next, a bulk crystal composed of Al_{b}Ga_{(1-b)}N (0 < b < 1) and having a primary surface was grown on the support substrate (Step S2). In Examples 1 to 4, as shown in Table I below, the composition ratio b of Al in the bulk crystal was smaller than the composition ratio a of Al in the support substrate. The composition ratio b of the primary surface, the growth method, and the growth temperature of the bulk crystal were as shown in Table I below. The primary surface of the bulk crystal was the c-plane.

In Examples 1 to 4, Al_{b}Ga_{(1-b)}N bulk crystals were manufactured through Steps S I and S2.

### COMPARATIVE EXAMPLES 1 and 2

An Al_{b}Ga_{(1-b)}N bulk crystal was manufactured by the same method as in Example 2 except that the composition ratio b (b = 0.5) of Al in the bulk crystal was larger than the composition ratio a (a = 0) of the support substrate, and the growth temperature was low as shown in Table I.

### EXAMPLES 5 to 8 and COMPARATIVE EXAMPLES 3 and 4

In Examples 5 to 8 and Comparative Examples 3 and 4, the Al_{b}Ga_{(1-b)}N bulk crystal manufacturing method basically had the same configuration as for the Al_{b}Ga_{(1-b)}N bulk crystals of Examples 1 to 4 and Comparative Examples 1 and 2 but was different in that a support substrate with the m-plane as the primary surface was used, and a bulk crystal was manufactured so that the primary surface was the m-plane.

### EXAMPLES 9 to 12 and COMPARATIVE EXAMPLES 5 and 6

In Examples 9 to 12 and Comparative Examples 5 and 6, the Al_{b}Ga_{(1-b)}N bulk crystal manufacturing method basically had the same configuration as for the Al_{b}Ga_{(1-b)}N bulk crystals of Examples 1 to 4 and Comparative Examples 1 and 2 but was different in that a support substrate with the a-plane as the primary surface was used, and a bulk crystal was manufactured so that the primary surface was the a-plane.

### (Measurement Method)

The thickness, growth rate, the presence of a first layer, and the dislocation density were examined for the AlGaN bulk crystals of Examples 1 to 12 and Comparative Examples 1 to 6. The results are shown in Tables I to III below.

The thickness was measured in a recessed portion (i.e., a portion with the smallest thickness) of the growth surface (primary surface) from the interface (back side) with the support substrate.

The growth rate was calculated from a time required for growing the AlGaN bulk crystal with each of the thicknesses.

The presence of the first layer was confirmed as follows: First, each of the AlGaN bulk crystals was cut along the growth direction (arrow 12c in Fig. 10). The concentrations in the cross section were measured by SIMS to observe the presence of the first layer in which a group III element was diffused. Fig. 10 is a sectional view illustrating the method for confirming the first layer.

The dislocation density was measured as follows: First, each of the AlGaN bulk crystals was etched by immersing for 30 minutes in a melt prepared by melting KOH and NaOH (sodium hydroxide) at a ratio of 1:1 in a platinum crucible at 250°C. Then, each of the AlGaN bulk crystals was washed, and the number of etch pits per unit area in the surface was counted with a microscope. For the dislocation density measured as described above, the dislocation density of 1 × 10⁴ cm⁻² or more and 5 × 10⁵ cm⁻² or less was evaluated as A, the dislocation density of over 5 × 10⁵ cm⁻² and 1 × 10⁷ cm⁻² or less was evaluated as B, the dislocation density of over 1 × 10⁷ cm⁻² and 1 × 10⁸ cm⁻² or less was evaluated as C, the dislocation density of over 1 × 10⁸ cm⁻² was evaluated as D, and unmeasurable dislocation density was evaluated as E.

**[Table I]**

| | Support substrate | Bulk crystal (primary surface: c plane) | | | | | | |
|---|---|---|---|---|---|---|---|---|
| | Composition | Composition | Growth method | Temperature | Growth rate | Thickness | Presence of first layer | Dislocation density |
| Example 1 | AIN | Al_{0.7}Ga_{0.3}N | Sublimation growth method | 1800°C | 180(µm/hr) | 4mm | Yes | A |
| Example 2 | Al_{0.8}Ga_{0.2}N | Al_{0.5}Ga_{0.5}N | HVPE method | 1650°C | 100(µm/hr) | 2mm | Yes | B |
| Example 3 | AIN | Al_{0.1}Ga_{0.9}N | Ga melt growth method | 1650°C(1GPa) | 50(µm/hr) | 1mm | Yes | A |
| Example 4 | Al_{0.8}Ga_{0.2}N | Al_{0.1}Ga_{0.9}N | HVPE method | 1300°C | 30(µm/hr) | 1mm | No | C |
| Comparative Example 1 | GaN | Al_{0.5}Ga_{0.5}N | HVPE method | 1000°C | 3(µm/hr) | 0.2mm | No | D |
| Comparative Example 2 | GaN | Al_{0.5}Ga_{0.5}N | HVPE method | 1400°C | - | - | - | E |

**Table II**

| | Support substrate | Bulk crystal (primary surface: m plane) | | | | | | |
|---|---|---|---|---|---|---|---|---|
| | Composition | Composition | Growth method | Temperature | Growth rate | Thickness | Presence of first layer | Dislocation density |
| Example 5 | AIN | Al_{0.7}Ga_{0.3}N | Sublimation growth method | 1800°C | 180(µm/hr) | 4mm | Yes | A |
| Example 6 | Al_{0.8}Ga₀₂N | Al_{0.5}Ga_{0.5}N | HVPE method | 1650°C | 100(µm/hr) | 2mm | Yes | B |
| Example 7 | AIN | Al_{0.1}Ga_{0.9}N | Ga melt growth method | 1650°C(1GPa) | 50(µm/hr) | 1mm | Yes | A |
| Example 8 | Al_{0.8}Ga_{0.2}N | Al_{0.1}Ga_{0.9}N | HVPE method | 1300°C | 30(µm/hr) | 1mm | No | C |
| Comparative Example 3 | GaN | Al_{0.5}Ga_{0.5}N | HVPE method | 1000°C | 3(µm/hr) | 0.2mm | No | D |
| Comparative Example 4 | GaN | Al_{0.5}Ga_{0.5}N | HVPE method | 1400°C | - | - | - | E |

**Table III**

| | Support substrate | Bulk crystal (primary surface: a plane) | | | | | | |
|---|---|---|---|---|---|---|---|---|
| | Composition | Composition | Growth method | Temperature | Growth rate | Thickness | Presence of first laver | Dislocation density |
| Example 9 | AlN | Al_{0.7}Ga_{0.3}N | Sublimation growth method | 1800°C | 180(µm/hr) | 4mm | Yes | A |
| Example 10 | Al_{0.8}Ga_{0.2}N | Al_{0.5}Ga_{0.5}N | HVPE method | 1650°C | 100(µm/hr) | 2mm | Yes | B |
| Example 11 | AlN | Al_{0.1}Ga_{0.9}N | Ga melt growth method | 1650°C(1GPa) | 50(µm/hr) | 1mm | Yes | A |
| Example 12 | Al_{0.8}Ga_{0.2}N | Al_{0.1}Ga_{0.9}N | HVPE method | 1300°C | 30(µm/hr) | 1mm | No | C |
| Comparative Example 5 | GaN | Al_{0.5}Ga_{0.5}N | HVPE method | 1000°C | 3(µm/hr) | 0.2mm | No | D |
| Comparative Example 6 | GaN | Al_{0.5}Ga_{0.5}N | HVPE method | 1400°C | - | - | - | E |

### (Evaluation Result)

Tables I to III indicate that in Examples 1 to 12 in which the composition ratio a of Al in the support substrate was larger than the composition ratio b of Al in the AlGaN bulk crystal, the AlGaN bulk crystals have a large thickness of 1 mm or more and a low dislocation density of 1 × 10⁸ cm⁻² or less. Therefore, it is found that in Examples 1 to 12, AlGaN bulk crystals of high quality having a large thickness can be grown. In addition, in Examples 1 to 12, since the bulk crystals are grown at a high temperature, the bulk crystals can be grown at a high growth rate of 30 µm/hr or more. In Examples 1 to 3, 5 to 7, and 9 to 11, a first layer in which at least one of Al element and Ga element as group III elements is diffused is formed.

In particular, in Examples 1, 5, and 9 in which the support substrate was composed of AlN, Al_{0.7}Ga_{0.3}N bulk crystals can be grown by a sublimation growth method at a high temperature of 1800°C. Therefore, the AlGaN bulk crystal of Example 1 has a low dislocation density of 1 × 10⁴ cm⁻² or more and 5 × 10⁵ cm⁻² or less. Further, a bulk crystal having a large thickness of 4 mm can be grown in spite of being grown at a high temperature.

On the other hand, in Comparative Examples 1 to 6 in which an Al_{0.5}Ga_{0.5}N bulk crystal (Al composition ratio b of 0.5) was grown on a support substrate (Al composition ratio a of 0) composed of GaN, the composition ratio a of Al in the support substrate is smaller than the composition ratio b of Al in the bulk crystal. Therefore, in Comparative Examples 1, 3, and 5 in which a bulk crystal was grown at a low temperature of 1000°C in order to suppress decomposition of the support substrate, large irregularity occurs in the surface, and the thickness of a recessed portion in the primary surface, which is a substantial thickness, is as small as 0.2 mm. In addition, a lattice constant of the bulk crystal is smaller than a lattice constant of the support substrate, and thus tensile stress is applied to the bulk crystal, thereby causing a high dislocation density of over 1 × 10⁸ cm⁻². Further, the growth rate is low because of the low growth temperature.

In Comparative Examples 2, 4, and 6 in which an AlGaN bulk crystal was grown at a higher temperature than in Comparative Examples 1, 3, and 5, the support substrate disappears in spite of a lower temperature than in Examples 1 to 12. Therefore, an AlGaN bulk crystal cannot be grown.

According to these examples, it was confirmed that when the composition ratio a of Al in the support substrate is larger than the composition ratio b of Al in the bulk crystal, a high-quality AlGaN bulk crystal having a large thickness can be manufactured. Also it was confirmed that an AlGaN bulk crystal can be manufactured so that the primary surface is any one of the c-plane, the a-plane, and the m-plane.

Next, in Examples 1 to 12, the support substrate was removed from each of the AlGaN bulk crystals after growth by slicing with a wire saw to produce an AlGaN bulk crystal.

In addition, in Examples 1 to 12, four AlGaN substrates were cut out from each of the grown AlGaN bulk crystals by slicing with a wire saw.

On the other hand, in Comparative Examples 1, 3, and 5, a plurality of AlGaN substrates could not be cut out because of the small thickness. In Comparative Examples 2, 4, and 6, the support substrate could not be removed because the AlGaN bulk crystal could not be grown, and thus an AlGaN substrate could not be manufactured.

According to these examples, it was confirmed that when the composition ratio a of Al in the support substrate is larger than the composition ratio b of Al in the bulk crystal, a high-quality AlGaN bulk crystal having a large thickness without having a support substrate can be manufactured. Also it was confirmed that when the composition ratio a of Al in the support substrate is larger than the composition ratio b of Al in the bulk crystal, an AlGaN bulk crystal having a large thickness can be manufactured, and thus a plurality of AlGaN substrates can be cut out from the AlGaN bulk crystal.

Although the embodiments and examples of the present invention are described above, combinations of the features of the embodiments and examples are considered from the beginning. In addition, the embodiments and examples disclosed here should be considered to be illustrative, not restrictive, from all viewpoints. The scope of the present invention is represented by the claims, not the embodiments, and the present invention is intended to include meanings equivalent to the claims and modification within the scope. Reference Signs List

10, 12 AlGaN bulk crystal, 10a, 11a, 12a, 20a primary surface, 11 support substrate, 12b back side, 12c arrow, 13 first layer, 14 second layer, 20 AlGaN substrate

## Claims

1. An AlGaN bulk crystal manufacturing method comprising:
a step of preparing a support substrate composed of AlₐGa₍₁₋ₐ₎N (0 < a ≤ 1); and
a step of growing a bulk crystal composed of Al_{b}Ga_{(1-b)}N (0 < b< 1) with a primary surface on the support substrate,
wherein the composition ratio a of Al in the support substrate is larger than the composition ratio b of Al in the bulk crystal.

2. The AlGaN bulk crystal manufacturing method according to Claim 1, wherein the bulk crystal having a thickness of 1 mm or more is grown in the growth step.

3. The AlGaN bulk crystal manufacturing method according to Claim 1 or 2, wherein the growth step includes:
a step of growing, on the support substrate, a first layer containing a group III element diffused therein; and
a step of growing a second layer composed of the Al_{b}Ga_{(1-b)}N on the first layer.

4. The AlGaN bulk crystal manufacturing method according to any one of Claims 1 to 3, wherein in the growth step, the bulk crystal is grown so that the Al concentration decreases from the support substrate side to the primary surface.

5. The AlGaN bulk crystal manufacturing method according to any one of Claims 1 to 4, wherein in the growth step, the bulk crystal is grown at 1650°C or more.

6. The AlGaN bulk crystal manufacturing method according to any one of Claims 1 to 5, wherein in the growth step, the bulk crystal is grown so that the primary surface is any one of a c-plane, an a-plane, and an m-plane.

7. The AlGaN bulk crystal manufacturing method according to any one of Claims 1 to 6, after the growth step, further comprising a step of removing at least the support substrate.

8. An AlGaN substrate manufacturing method comprising:
a step of manufacturing an AlGaN bulk crystal by the AlGaN bulk crystal manufacturing method according to any one of Claims 1 to 7; and
a step of cutting out at least one Al_{b}Ga_{(1-b)}N substrate from the bulk crystal.
